# EUROPÄISCHE PATENTSCHRIFT

(11) **EP 0 767 408 B1**
(45) Veröffentlichungstag und Bekanntmachung des Hinweises auf die Patenterteilung: **28.11.2001**
(21) Anmeldenummer: 96115278.2
(22) Anmeldetag: 24.09.1996
(51) Int. Cl.: G03F 1/00, G03F 7/095

(54) **Verfahren zur Herstellung von photopolymeren Tiefdruckplatten**
Process for the production of photopolymer intaglio printing plates
Procédé pour la production des plaques d'impression en creux

(30) Priorität: 02.10.1995 DE 19536806
(43) Veröffentlichungstag der Anmeldung: 09.04.1997
(73) Patentinhaber: BASF Drucksysteme GmbH, 70469 Stuttgart (DE)
(72) Erfinder: Goffing, Friedrich, Dr., 67117 Limburgerhof (DE); Loerzer, Thomas, Dr., 76829 Landau (DE); Sandig, Hartmut, Dr., 67227 Frankenthal (DE); Tönnessen, Markus, 67122 Mutterstadt (DE)
(74) Vertreter: Paashaus, Sabine Dr.

(56) Entgegenhaltungen:
- EP-A- 0 634 695
- EP-A- 0 720 057
- WO-A-94/03838
- DE-A- 3 342 579
- PATENT ABSTRACTS OF JAPAN vol. 7, no. 138 (P-204), 16.Juni 1983 & JP-A-58 052646 (DAINIPPON ISATSU KK), 28.März 1983,
- PATENT ABSTRACTS OF JAPAN vol. 10, no. 190 (P-474), 4.Juli 1986 & JP-A-61 036750 (RICOH CO., LTD.), 21.Februar 1986,

## Beschreibung

Die vorliegende Erfindung betrifft ein Verfahren zur Herstellung von photopolymeren Tiefdruckplatten aus einem wässrig oder wässrig-alkoholisch entwickelbaren photopolymerisierbarem Aufzeichnungselement welches übereinander angeordnet einen dimensionsstabilen Träger, optional eine Haftschicht, eine durch aktinische Strahlung vernetzbare Schicht (A), eine sauerstoffdurchlässige Trennschicht (T), eine gegen IR-Strahlung empfindliche Schicht (B) sowie eine abziehbare Schutzfolie aufweist, durch Abziehen der Schutzfolie, Laserablation der Schicht (B), Belichten mit aktinischer Strahlung in Gegenwart von Luftsauerstoff und Entwickeln.

Wasserentwickelbare oder wäßrig-alkoholisch entwickelbare photo-polymere Tiefdruckplatten bestehen aus einer im Entwickler löslichen oder dispergierbaren, lichtempfindlichen photopolymerisierbaren Schicht, die auf einem dimensionsstabilen Träger, z.B. Polyethylenterephthalatfolie, Stahl- oder Aluminiumblech, aufgebracht ist. Um den Verbund haftfest auszurüsten, kann zwischen der wasser- oder wäßrig-alkoholisch entwickelbaren lichtempfindlichen, photopolymerisierbaren Schicht und dem Träger eine Adhäsionsschicht appliziert werden.

Auf der wasser- oder wässrig/alkoholisch entwickelbaren, lichtempfindlichen, photopolymerisierbaren Schicht kann sich noch eine Deckschicht befinden, die immer dann benötigt wird, wenn die darunter befindliche wasser- oder wäßrig/alkoholisch entwickelbare, lichtempfindliche, photopolymerisierbare Schicht so klebrig ist, daß beim Auflegen des photographischen Negatives die vorhandene Luft im Vakuumbelichtungsrahmen nicht gleichmäßig entfernt werden kann und in der Folge sogenannte Vakuumfehler beim Belichten entstehen.

Die wasser- oder wäßrig/alkoholisch entwickelbaren, lichtempfindliche, photopolymerisierbare Schicht kann gegen mechanische Beschädigungen durch eine Schutzfolie geschützt werden, die sich entweder auf der wasser- oder wäßrig/alkoholisch entwickelbaren, lichtempfindlichen, photopolymerisierbaren Schicht oder auf der darauf befindlichen Deckschicht befindet. (vgl.z.B. Ullmannn's Encyclopedia of Industrial Chemistry, Vol. A 13, Seite 629).

Auf diese wasser- oder wässrig/alkoholisch entwickelbare, lichtempfindliche photopolymerisierbare Schicht werden im allgemeinen nach Entfernen der Schutzfolie, falls vorhanden, durch Auflegen des photographischen Negatives, Entfernen der Luft mittels Vakuumrahmen und vollflächiges Belichten die im photographischen Negativ enthaltenen Informationen übertragen. Die Näpfchentiefe der Tiefdruckform, und damit die beim Druckprozeß übertragene Farbmenge, wird dabei über die Belichtungszeit gesteuert.

Im anschließenden Entwicklungsschritt lassen sich die nicht polymerisierten Bereiche, die Näpfchen, mit Hilfe von Wasser oder Wasser/Alkohol-Mischungen auswaschen; die photopolymerisierten Bereiche sind nicht löslich bzw. nicht dispergierbar und bilden so die Oberfläche der Tiefdruckplatte. Um das Wasser oder die Wasser/Alkohol-Mischung aus der angequollenen Reliefschicht zu entfernen, schließt sich ein Trocknungsschritt an. Je nach lichtempfindlichem Material kann die Platte noch weitere Bearbeitungsschritte benötigen. So ist bei manchen Druckformen eine vollflächige Nachbelichtung erforderlich, um die Druckform vollständig auszuhärten.

Bei diesem Verfahren wird die Information also über ein photographisches Negativ übertragen. Nach dem Stand der Technik werden photographische Negative durch Belichtung eines lichtempfindlichen Films mittels eines Belichters z.B. optomechanische Belichter, CRT-Belichter (cathode ray tube) oder Laserbelichter (He-Ne-Laser, λ = 632 nm) ,mit nachfolgender Entwicklung hergestellt (vgl. z.B. Armin Lautert, Allgemeine Fachkunde der Drucktechnik, Seite 42 - 45, 11. Auflage 1993, Baden-Verlag CH-Baden).

Die Information, die so auf den Film übertragen wird, entstammt dabei einem digitalisierten Datenbestand. Beim rotativen Tiefdruck kann durch die Verwendung eines Negativs die Druckform nicht naht- und endlos hergestellt werden.

Aus diesen Gründen wäre es wünschenswert, wenn eine Tiefdruckform ohne den Umweg über ein photographisches Negativ hergestellt werden könnte.

Neben den verkürzten Herstellzeiten würden die Kosten für die Herstellung eines photographischen Negatives entfallen. Außerdem würden die naßchemischen Prozesse bei der Filmentwicklung nicht mehr benötigt werden. Das wäre mit dem ökologischen Vorteil verbunden, daß keine mit Chemikalien und Metallsalzen belasteten Abwässer mehr anfielen.

Zudem können sich die geometrischen Maße eines photographischen Negatives durch Temperatur und Luftfeuchtigkeit ändern, was zu Registerproblemen der fertigen Tiefdruckform führen kann, da beim Belichten einer entsprechenden lichtempfindlichen photopolymerisierbaren Schicht die Information des photographischen Negatives projizierend 1:1 übertragen wird.

Nach dem Stand der Technik wird eine UV-Belichtung durch ein photographisches Negativ hindurch unter Anlegen von Vakuum ausgeführt, da ein intensiver Kontakt zwischen Negativ und Plattenoberfläche notwendig ist, um seitliche Unterstrahlung und Kopierfehler zu vermeiden. Durch den Druck, der für den intensiven Kontakt zwischen Plattenoberfläche und Negativ notwendig ist, kann es zu Eindrücken von Staubpartikeln und damit zu Löchern in der Plattenoberfläche kommen, die später im Druckprozeß unerwünscht Farbe übertragen.

Wünschenswert wäre jedoch eine UV-Belichtung ohne Vakuum, d.h. in Gegenwart von Luftsauerstoff, um die inhibierende Wirkung des Luftsauerstoffs ausnutzen zu können, um die Näpfchentiefen mit geringerer Streuung steuern zu können und um die durch Staubpartikel verursachten Oberflächenfehler zu vermeiden.

Digitale Verfahren, bei denen kein photographisches Negativ zur Informationsübertragung benötigt wird, sind schon seit langem bekannt.

So wird z.B. in der DE 4117127 A1 ein Verfahren beschrieben, bei dem eine Bildmaske auf lichtempfindlichen Aufzeichnungselementen durch Nutzung eines Tintenstrahldruckers oder eines elektrophotographischen Druckers erzeugt wird. Nachteil ist hierbei, daß die Auflösung für den Hochqualitätstiefdruck nicht ausreicht.

In der EP 0001138-A1 wird ein Verfahren zur Herstellung von lithographischen Druckplatten unter Bildung eines "fugitive negative" beschrieben.

In WO 94/03839 wird ein Verfahren beschrieben, bei dem mittels eines IR-Lasers ein lichtempfindliches Aufzeichnungselement strukturiert wird und auf diese Weise eine Bildmaske erzeugt wird. Das lichtempfindliche Aufzeichnungsmaterial besteht hier aus einem Träger, einer lichtempfindlichen Schicht, einer IR-lichtempfindlichen Schicht, die für aktinisches Licht opak ist und einer Folie. Bei der Belichtung mit dem IR-Laser werden nun die belichteten Stellen der IR-lichtempfindlichen Schicht an der darüberliegenden Folie fixiert und können durch Abziehen der Folie mit entfernt werden. Man erhält so eine Bildmaske auf der lichtempfindlichen Aufzeichnungsschicht. Nachteilig ist hier, daß Beschädigungen, wie z.B. Kratzer der Folie, die gleichzeitig auch als mechanischer Schutz dienen soll, zu einer fehlerhaften Informationsübertragung führt. Des weiteren besteht insbesondere bei feinen Elementen beim Abziehen der Folie die Gefahr, umliegende Bereiche, die auf dem lichtempfindlichen Aufzeichnungsmaterial verbleiben sollen, zu beschädigen, was ebenfalls zu einer fehlerhaften Informationsübertragung führt.

JP-A 83-52646 offenbart ein photoempfindliches Aufzeichnungsmaterial zur Herstellung von Flexodruckplatten. Auf die photopolymerisierbare Schicht ist eine zusätzliche Schicht aus Kupfer, Nickel, Chrom oder Silbersalzen aufgebracht. Diese Schicht ist laserbeschreibbar, d.h. an den Stellen, die vom Laserstrahl getroffen werden, verdampft die Schicht, die photopolymerisierbare Schicht wird freigelegt und kann im Folgeschritt mit aktinischer Strahlung gehärtet werden.

In US-A-5 262 275 und WO 94/03838 wird ein Verfahren beschrieben, bei dem mittels IR-Laser Flexodruckformen digital strukturiert werden. Das Aufzeichnungselement besteht aus einem Träger, einer lichtempfindlichen flexographischen Schicht, einer Sperrschicht und einer IR-lichtempfindlichen Schicht, die für aktinisches Licht opak ist. Die IR-lichtempfindliche Schicht wird direkt mit dem IR-Laser beschrieben, wobei an den beschriebenen Stellen das IR-lichtempfindliche Material verdampft und damit an diesen Stellen für aktinisches Licht durchlässig wird. Die unter der IR-lichtempfindlichen Schicht liegende Barriereschicht schützt zum einen die IR-lichtempfindliche Schicht gegen Diffusion von Monomeren und anderen Bestandteilen aus der UV-lichtempfindlichen flexographischen Schicht und verhindert den Zutritt von Sauerstoff in die UV-empfindliche flexographische Schicht während der UV-Belichtung. Wie in WO 94/03838 beschrieben, ist die UV-Belichtung in Anwesenheit von Luftsauerstoff nicht reproduzierbar. Darüber hinaus werden in Anwesenheit von Sauerstoff längere Belichtungszeiten benötigt. Es werden also Barriereschichten eingesetzt, die nicht sauerstoffdurchlässig sind.

Es stellte sich daher die Aufgabe, eine wasserentwickelbare oder wässrig/alkoholisch entwickelbare Tiefdruckform zu entwickeln, die mittels eines IR-Lasers digital beschrieben werden kann und die im anschließenden Schritt mit UV-Licht mit guter Reproduzierbarkeit in Gegenwart von Luftsauerstoff vollflächig belichtet werden kann.

Überraschend wurde gefunden, daß dies mit dem erfindungsgemäßen Verfahren gelingt, wobei ein wasserentwickelbares oder wässrig/ alkoholisch entwickelbares, lichtempfindliches Aufzeichnungsmaterial die genannten Nachteile überwindet.

Gegenstand der vorliegenden Erfindung ist ein Verfahren zur Herstellung von photopolymeren Tiefdruckplatten aus einem wässrig oder wässrig-alkoholisch entwickelbaren photopolymerisierbaren Aufzeichnungselement, umfassend übereinander angeordnet
- einen dimensionsstabilen Träger,
- optional eine Haftschicht,
- eine durch aktinische Strahlung vernetzbare Schicht (A),
- eine Trennschicht (T) zwischen (A) und (B),
- eine gegen IR-Strahlung empfindliche Schicht (B), sowie
- eine auf (B) angebrachte abziehbare Schutzfolie,
welches dadurch gekennzeichnet ist, dass
- die Schicht (A) aus einem Gemisch aus mindestens einem in Wasser oder Wasser/Alkohol-Gemischen löslichen oder dispergierbaren Bindemittel, mit diesem Bindemittel verträglichen copolymerisierbaren, ethylenisch ungesättigten organischen Verbindungen, einem Photoinitiator oder Photoinitiatorsystem sowie optional weiteren Hilfsstoffen besteht,
- die Trennschicht (T) sauerstoffdurchlässig und in Wasser oder Wasser/Alkohol-Gemischen löslich oder dispergierbar ist,
- die gegen IR-Strahlung empfindliche Schicht (B) im aktinischen Bereich eine optische Dichte ≥ 2,5 aufweist und ein in Wasser oder einem Wasser/Alkohol-Gemisch lösliches oder dispergierbares, filmbildendes polymeres Bindemittel sowie mindestens eine im Bindemittel fein verteilte Substanz, die im Wellenlängenbereich zwischen 750 nm und 20000 nm eine hohe Absorption aufweist, enthält,
indem nach Abziehen der Schutzfolie die Strukturierung der gegen IR-Strahlung empfindlichen Schicht (B) durch Laserablation erfolgt, dann vollflächig mit aktinischer Strahlung in Gegenwart von Luftsauerstoff belichtet, mit Wasser oder Wasser/Alkohol-Gemischen entwickelt und in üblicher Weise getrocknet wird.

Das erfindungsgemäße Verfahren ist hervorragend für die Herstellung von Tiefdruckplatten durch digitale Informationsübertragung geeignet.

Als dimensionsstabile Träger kommen die für die Tiefdruckplattenherstellung üblichen in Frage.

Beispiele geeigneter dimensionsstabiler Träger sind Platten, Folien sowie konische und zylindrische Röhren (sleeves) aus Metallen wie Stahl, Aluminium, Kupfer oder Nickel oder aus Kunststoffen wie Polyethylenterephthalat, Polybutylenterephthalat, Polyamid und Polycarbonat, Gewebe und Vliese wie Glasfasergewebe sowie Verbundmaterialien aus Glasfasern und Kunststoffen.

Als dimensionsstabile Träger kommen insbesondere dimensionsstabile Trägerfolien und Metallbleche, beispielsweise Polyethylen- oder Polyesterfolien bzw. Bleche aus Stahl, Edelstahl oder Aluminium, in Frage. Diese Trägerfolien bzw. -bleche sind im allgemeinen zwischen 50 und 1100 µm, vorzugsweise 75 bis 700 µm, beispielsweise ca. 300 µm dick.

Diese Trägerfolien oder -bleche können mit einer dünnen haftvermittelnden Schicht, beispielsweise einer 1 bis 5 µm dicken Schicht auf der der lichtempfindlichen Aufzeichnungsschicht zugewandten Seite der Trägerfolie beschichtet sein. Diese Haftschicht kann beispielsweise aus einem Gemisch aus einem Polycarbonat, einem Phenoxyharz und einem multifunktionellen Isocyanat bestehen.

Die photostrukturierbare Schicht (A) kann sich, gegebenenfalls auch mittels einer Haftschicht und einer Oberlackschicht, auf dem dimensionsstabilen Träger befinden.

Als Haftlackschichten können beispielsweise Polyurethanhaftlacke, (z.B. gemäß DE-A-30 45 516) auf Basis von polyisocyanatvernetzten Polyether- oder Polyesterlacken in Schichtdicken zwischen 0,5 und 50, insbesondere zwischen 2 und 30 µm dienen.

Oberlackschichten können sich auf der von der Trägerschicht abgewandten Seite der Haftlackschicht befinden, weisen Schichtdicken zwischen 0,1 und 50, insbesondere zwischen 1 und 10 µm, auf und können beispielsweise aus verdünnter wäßrig/alkoholischer Lösung von (zu z.B: 80 Mol%) teilverseiften Polyvinylester, Phenylglycerinethermonoacrylat und Glyoxal, Trocknen und Einbrennen erhalten werden.

Bei der durch aktinische Strahlung vernetzbaren, d.h. photostrukturierbaren, reliefbildenden, Schicht (A) handelt es sich erfindungsgemäß um ein Gemisch aus mindestens einem in Wasser oder Wasser/Alkohol-Gemischen löslichen oder dispergierbaren polymeren Bindemittel, mit diesem polymeren Bindemittel verträglichen copolymerisierbaren ethylenisch ungesättigten organischen Verbindungen, einem Photoinitiator oder Photoinitiatorsystem, sowie gegebenenfalls weiteren Hilfs- und Zusatzstoffen, wie Inhibitoren der thermischen Polymerisation, Weichmacher und/oder Farbstoffen, wobei als Alkohole in den Wasser/Alkohol-Gemischen Methanol, Ethanol, n-Propanol und Isopropanol, vorzugsweise Ethanol in Frage kommen.

Als polymere Bindemittel kommen die für den Aufbau von Druckplatten üblichen in Betracht, wie vollständig oder teilweise verseifte Polyvinylester, z.B. teilverseifte Polyvinylacetate, Polyvinylalkoholderivate, wie z.B. teilverseiftes Vinylacetat/Alkylenoxid-Pfropfmischpolymerisat, oder nachträglich polymeranalog acrylierte Polyvinylalkohole, wie sie beispielsweise in EP-A-0079514, EP-A-0224164, oder EP-A-0059988 beschrieben sind, sowie deren Gemische.

Ebenso eignen sich als polymere Bindemittel in Wasser oder Wasser/Alkohol-Mischungen lösliche Polyamide, wie sie beispielsweise in EP-A-0085472 oder in DE-A-1522444 beschrieben sind.

Diese polymeren Bindemittel machen in der photostrukturierbaren Schicht (A) im allgemeinen 50 bis 98, vorzugsweise 60 bis 95 Gew.-% der Gesamtmenge der photostrukturierbaren Schicht (A) aus.

Als copolymerisierbare ethylenisch ungesättigte organische Verbindungen kommen solche in Betracht, die mit den jeweils ausgewählten polymeren Bindemitteln verträglich sind. Im allgemeinen sind dies bei Raumtemperatur nicht gasförmige ein- und/oder mehrfach olefinisch ungesättigte organische Verbindungen, insbesondere Derivate der Acryl- und/oder Methacrylsäure, wie deren Ester mit ein- oder mehrwertigen Alkoholen, beispielsweise Acryl- oder Methacrylsäureester von Alkanolen mit 1 bis 20 Kohlenstoffatomen, wie Methylmethacrylat, Ethylacrylat, Propyl(meth)acrylat, Isopropyl(meth)acrylat, n-Butyl(meth)acrylat, Isobutyl(meth)acrylat, tert.-Butyl-(meth)acrylat, Hexyl(meth)acrylat, Cyclohexyl(meth)acrylat, 2-Ethyl-hexyl(meth)acrylat, Lauryl(meth)acrylat, (Meth)acrylester mehrwertiger Alkohole mit 2 bis 20 Kohlenstoffatomen, z.B. 2-Hydroxyethyl(meth)acrylat, 2-Hydroxypropyl(meth)acrylat, Ethylenglykoldi(meth)acrylat, Polyethylenglykoldi(meth)acrylat, Butandiol-1,4-di(meth)acrylat, Neopentylglykol-di(meth)acrylat, 3-Methylpentandiol-di(meth)acrylat, 1,1,1-Trimethylolpropantri(meth)acrylat, Di-, Tri- und Tetraethylenglykoldi(meth)acrylat, Tripropylenglykol-di(meth)acrylat oder Pentaerythrit-tetra(meth)acrylat, des weiteren Poly(ethylenoxid)di(meth)acrylat, ω-Methylpoly(ethylenoxid)-yl-(meth)acrylat, N,N-Diethylaminoethylacrylat, ein Umsetzungsprodukt aus 1 Mol Glycerin, 1 Mol Epichlorhydrin und 3 Mol Acrylsäure sowie Glycidylmethacrylat und Bisphenol-A-diglycidetheracrylat.

Ebenso eignen sich Derivate des Acrylamids und des Methacrylamids, wie z.B. Ether ihrer N-Methylolderivate mit ein- und mehrwertigen Alkoholen, z.B. Ethylenglykol, Glycerin, 1,1,1-Trimethylolpropan, oligomeren oder polymeren Ethylenoxidderivaten. Diese eignen sich besonders, wenn Polyamide oder Polyvinylalkohol als Bindemittel eingesetzt werden.

Geeignet sind auch sogenannte Epoxid- und Urethan(meth)acrylate, wie sie beispielsweise durch Umsetzung von Bisphenol-A-diglycidylether mit (Meth)acrylsäure oder durch Umsetzung von Diisocyanaten mit Hydroxyalkyl(meth)acrylaten oder mit hydroxylgruppenhaltigen Polyestern oder Polyethern erhalten werden können. Weiterhin einsetzbare olefinisch ungesättigte organische Verbindungen sind Ester der Acryl- oder Methacrylsäure, insbesondere solche mit niedrigem Dampfdruck und solche, die mit Verträglichkeitsvermittlern modifiziert sind, z.B. mit Hydroxy-, Amido-, Sulfoester- oder Sulfonamidgruppen. Auch Gemische der obengenannten copolymerisierbaren ethylenisch ungesättigten organischen Verbindungen können eingesetzt werden. Die copolymerisierbaren ethylenisch ungesättigten organischen Verbindungen können in der photostrukturierbaren Schicht in Mengen von 1 bis 60, vorzugsweise 10 bis 45 Gew.-%, bezogen auf die Gesamtmenge der photostrukturierbaren Schicht enthalten sein.

Als Photoinitiatoren oder Photoinitiatorsysteme kommen die für lichtempfindliche Aufzeichnungsmaterialien allgemein üblichen in Frage, beispielsweise radikalliefernde Photoinitiatoren, wie z.B. Benzoin oder Benzoinderivate, wie Benzoinether geradkettiger oder verzweigter Monoalkohole mit 1 bis 6 Kohlenstoffatomen z.B. Benzoinmethyl-, -ethyl-, -isopropyl-, -n-butyl-, -isobutylether, symmetrisch oder unsymmetisch substituierte Benzilacetale, wie Benzildimethylacetal, Benzil-1-methyl-1-ethylacetal, Diarylphosphinoxide, wie z.B. 2,4,6-Trimethylbenzoyldiphenylphosphinoxid oder 2,6-Dimethoxybenzoyldiphenylphosphinoxid, 2,4,6-Trimethylbenzoyl-phenylphosphinsäureethylester oder Acyldiarylphosphinoxide gemäß DE-OS-29 09 992, Diacylphosphinoxide oder substituierte und unsubstituierte Chinone, wie Ethylanthrachinon, Benzanthrachinon, Benzophenon oder 4,4'-Bis(dimethylamino)benzophenon. Sie können allein oder im Gemisch miteinander oder in Verbindung mit Coinitiatoren verwendet werden, z.B. Ethylanthrachinon mit 4,4'-Bis(dimethylamino)benzophenon, Benzoinmethylether mit Triphenylphosphin, Diacylphosphinoxide mit tertiären Aminen oder Acyldiarylphosphinoxide mit Benzildimethylacetal.

Die Photoinitiatoren sind in der photostrukturierbaren Schicht (A) üblicherweise in Mengen von 0,1 bis 10, vorzugsweise 0,5 bis 5 Gew.-%, bezogen auf die Gesamtmenge der photostrukturierbaren Schicht, enthalten.

Außer polymeren Bindemittel, copolymerisierbaren olefinisch ungesättigten organischen Verbindungen und Photoinitiator können in der photostrukturierbaren Schicht (A) weitere Hilfs- und Zusatzstoffe enthalten sein, beispielsweise können in Mengen von 0,001 bis 2 Gew.-%, bezogen auf die Gesamtmenge der photostrukturierbaren Schicht, Inhibitoren gegen die thermische Polymerisation, die keine nennenswerte Eigenabsorption in dem aktinischen Bereich, in dem der Photoinitiator absorbiert, aufweisen, zugesetzt werden, wie z.B. 2,6-Di-tert.-butyl-p-kresol, Hydrochinon, p-Methoxyphenol, β-Naphthol, Phenothiazin, Pyridin, Nitrobenzol, m-Dinitrobenzol oder Chloranil; Thiazinfarbstoffe, wie Thioninblau G (C.I. 52025) , Methylenblau B (C.I. 52015) oder Toluidinblau (C.I. 52040); oder N-Nitrosamine, wie N-Nitrosodiphenylamin, oder die Salze, beispielsweise die Kalium-, Calcium- oder Aluminiumsalze des N-Nitrosocyclohexylhydroxylamins.

Auch geeignete Farbstoffe, Pigmente oder photochrome Zusätze können der erfindungsgemäßen photostrukturierbaren Schicht (A) in einer Menge von 0,0001 bis 2 Gew.-%, bezogen auf das Gemisch der Schicht (A), zugesetzt sein. Sie dienen der Steuerung der Belichtungseigenschaften, der Identifizierung, der direkten Kontrolle des Belichtungsergebnisses oder ästhetischen Zwecken. Voraussetzung für die Auswahl und die Menge solcher Zusätze ist, daß sie ebensowenig wie die Inhibitoren der thermisch initiierten Polymerisation die Photopolymerisation der Gemische stören. Geeignet sind z.B. die löslichen Phenazinium-, Phenoxazinium-, Acridinium- und Phenothiaziniumfarbstoffe, wie Neutralrot (C.I. 50040), Safranin T (C.I. 50240), Rhodanilblau, das Salz bzw. Amid aus Rhodamin D (Basic Violet 10, C.I. 45170), Methylenblau B (C.I. 52015), Thioninblau G (C.I. 52025), oder Acridinorange (C.I. 46005); sowie auch Solvent Black 3 (C.I. 26150). Diese Farbstoffe können auch zusammen mit einer hinreichenden Menge eines Reduktionsmittels verwendet werden, welches den Farbstoff in Abwesenheit von aktinischem Licht nicht reduziert, bei Belichtung jedoch den Farbstoff im angeregten Elektronenzustand reduzieren kann. Beispiele solcher milden Reduktionsmittel sind Ascorbinsäure, Anethol, Thioharnstoff, z.B. Diethylallylthioharnstoff, insbesondere N-Allylthioharnstoff, sowie Hydroxylaminderivate, insbesondere Salze des N-Nitrosocyclohexylhydroxylamins, vorzugsweise die Kalium-, Calcium- und Aluminiumsalze. Letztere können, wie erwähnt, zugleich als Inhibitoren der thermisch initiierten Polymerisation dienen. Die Reduktionsmittel können im allgemeinen in Mengen von 0,005 bis 5 Gew.-%, bezogen auf das Gemisch der Schicht (A), zugesetzt werden, wobei sich in vielen Fällen der Zusatz eines 3- bis 10-fachen der Menge an mitverwendetem Farbstoff bewährt hat.

Zur Erhöhung der Kratz- und Abriebfestigkeit können feinteilige, harte, abrasive Partikel, wie sie in DE-A-3128949 (EP 070511) beschrieben sind, zugesetzt werden. Als abrasive Partikel können beispielsweise Siliciumdioxide, insbesondere Quarzmehl, Silikate, wie Aluminiumsilikate oder Silikatgläser, Aluminiumoxide, insbesondere Korund, Titandioxid und/oder Carbide wie Siliciumcarbid oder Wolframcarbid verwendet werden.

Die Herstellung der photostrukturierbaren Schicht (A) aus den einzelnen Bestandteilen kann in der üblichen Weise durch Mischen der Bestandteile mit Hilfe bekannter Mischmethoden und durch Verarbeitung dieser Mischung zur photostrukturierbaren Schicht mit Hilfe bekannter Techniken, wie Gießen aus Lösung, Kalandrieren oder Extrudieren, erfolgen, wobei diese Maßnahmen auch in geeigneter Weise miteinander kombiniert werden können. Die Stärke der photostrukturierbaren Schicht beträgt zweckmäßigerweise ca. 0,03 mm bis 2 mm, insbesondere 100 µm bis 1000 µm.

Auf der photostrukturierbaren Schicht befindet sich die gegen IR-Strahlung empfindliche Schicht (B), die laserablatierbar ist sowie eine Zwischenschicht (T) aus einem sauerstoffdurchlässigen entwicklerlöslichen oder -dispergierbaren Polymer.

Eine derartige Zwischenschicht vermag die Diffusion von Monomeren aus der lichtempfindlichen, photopolymerisierbaren Schicht in die darüberliegende IR-lichtempfindliche Schicht (B) zu verringern und die lichtempfindliche, photopolymerisierbare Schicht gegen die Einwirkung des Laserstrahls bei der Laserablation zu schützen. Darüber hinaus ist diese Zwischenschicht durchlässig gegenüber Luftsauerstoff, so daß während der der Laserablation folgenden UV-Belichtung Luftsauerstoff zutreten kann und damit eine genauere Steuerung der Näpfchentiefe erzielt wird.

Beispiele für derartige als sauerstoffdurchlässige Zwischenschichten geeignete wasser- oder wässrig/alkoholisch lösliche oder dispergierbare Polymere sind teilverseifte Polyvinylester, z.B. teilverseifte Polyvinylacetate, Polyvinylalkoholderivate, wie z.B. teilverseiftes Vinylacetat/Alkylenoxid-Pfropfmischpolymerisat, Maleinsäureanhydridcopolymere wie z.B. Copolymere aus Maleinsäureanhydrid und Isobuten oder Maleinsäureanhydrid und Vinylmethylether, wasserlösliche Polyester, wasserlösliche Polyether, Homo- und Copolymere von Vinylpyrrolidon, Vinylcaprolactam, Vinylimidazol, Vinylacetat, Acrylamid, wasserlösliche Polyurethane, in Wasser oder Wasser-Alkohol-Mischungen lösliche Polyamide oder Mischungen dieser Polymeren.

Die gegen IR-Strahlung empfindliche Schicht (B) besteht aus einem oder mehreren wasserlöslichen oder wasserdispergierbaren oder wäßrig/alkoholisch löslichen oder dispergierbaren Bindemittel, einem in diesem Bindemittel fein verteilten IR-lichtabsorbierenden Material mit einer starken Absorption im Wellenlängenbereich von 750 bis 20000 nm, bevorzugt von 750 bis 5000 nm und gegebenenfalls einem Weichmacher. Die IR-lichtempfindliche Schicht (B) weist gegenüber aktinischem Licht eine optische Dichte von ≥ 2,5, bevorzugt zwischen 3 und 5 auf.

Beispiele für derartige Bindemittel sind teilverseifte Polyvinylester, z.B. teilverseifte Polyvinylacetate, Polyvinylalkoholderivate, wie z.B. teilverseiftes Vinylacetat/Alkylenoxid-Pfropfmischpolymerisat, Maleinsäureanhydridcopolymere wie z.B. Copolymere aus Maleinsäureanhydrid und Isobuten oder Maleinsäureanhydrid und Vinylmethylether, wasserlösliche Polyester, wasserlösliche Polyether, Homo- und Copolymere von Vinylpyrrolidon, Vinylcaprolactam, Vinylimidazol, Vinylacetat, Acrylamid, wasserlösliche Polyurethane, wasserlösliche oder in Wasser/Alkohol-Mischungen lösliche Polyamide oder Mischungen dieser Polymeren.

Als IR-absorbierendes Material können Farbstoffe und/oder Pigmente eingesetzt werden. Als Farbstoffe können beispielsweise Phthalocyanine und substituierte Phthalocyanin-Derivate, Cyanin-, und Merocyaninfarbstoffe oder auch Polymethinfarbstoffe verwendet werden. Als Pigmente können z.B. Ruß, Graphit, Chromoxid oder Eisenoxide eingesetzt werden.

Das IR-absorbierende Material wird in der Konzentration eingesetzt, in der es für die erfindungsgemäße Anwendung wirksam ist. Im allgemeinen werden 1 bis 60 Gew.-%, bezogen auf das Gesamtgewicht der gegen IR-Strahlung empfindlichen Schicht (B) benötigt.

Um die IR-lichtempfindliche Schicht (B) gegenüber aktinischem Licht undurchlässig zu machen, können alle Verbindungen eingesetzt werden, die UV-Licht absorbieren. Beispiele sind die oben genannten Farbstoffe und Pigmente. Die meisten Initiatoren in lichtempfindlichen Schichten sind empfindlich gegenüber UV-Licht. Deshalb wird häufig Ruß als Pigment in der IR-lichtempfindlichen Schicht verwendet. Bei Verwendung von Ruß als Pigment in der IR-lichtempfindlichen Schicht kann auf die Verwendung eines weiteren IR-absorbierenden Materials verzichtet werden. Die Konzentration des für aktinisches Licht undurchlässigen Materials wird so gewählt, daß die notwendige optische Dichte erreicht wird. Im allgemeinen wird eine optische Dichte größer 2,5 benötigt. Bei Verwendung von Ruß als Pigment in der IR-lichtempfindlichen Schicht (B) werden ca. 1 bis 60 Gew.-%, bevorzugt 10 bis 40 Gew.-%, bezogen auf das Gesamtgewicht der IR-lichtempfindlichen Schicht (B) verwendet.

Zur Herstellung der IR-lichtempfindlichen Schicht (B) eignen sich als Lösungsmittel vorzugsweise Wasser und/oder wassermischbare örganische Lösungsmittel, wie z.B. Alkohole wie Methanol, Ethanol, iso-Propanol, n-Propanol oder Tetrahydrofuran. Nach Vereinigung der Bestandteile Bindemittel, IR-absorbierendes Material und gegebenenfalls weiteren Hilfsmitteln wie Weichmacher, Tenside, Verlaufshilfsmittel werden diese in einem üblichen Misch- oder Dispergierorgan wie Rührer oder Dissolver, homogen miteinander vermischt. Die Konzentration des Bindemittels und des IR-absorbierenden Materials beträgt zwischen 1% und 80 Gew.-%, bezogen auf die gesamte Lösung. Nach Aufgießen der Lösung auf eine Folie, z.B. aus Polyethylenterephthalat wird ein dünner Film erhalten, der dann getrocknet wird. Der getrocknete Film hat eine Dicke von 0,5 bis 15 µm, bevorzugt 3 bis 10 µm.

Das Aufbringen der Zwischenschicht kann in einem weiteren Gießschritt erfolgen, indem eine verdünnte Lösung des Bindemittels der Zwischenschicht auf die IR-lichtempfindliche Schicht gegossen wird und sofort getrocknet wird. Die Dicke der sauerstoffdurchlässigen Schicht kann zwischen 1 und 10 µm betragen. Die photostrukturierbaren Schicht (A) kann dann in einem weiteren Schritt aufgebracht werden.

Ein anderes Verfahren zur Herstellung des erfindungsgemäßen Schichtaufbaus geht von einer Tiefdruckplatte aus, die nach beschriebener Vorgehensweise hergestellt wird, bei der gegebenenfalls die Zwischenschicht zwischen UV-lichtempfindlicher Schicht und Schutzfolie aufgebracht ist. Nach Entfernen der Schutzfolie wird die oben beschriebene IR-lichtempfindliche Schicht, gegebenenfalls unter Verwendung eines Lösemittels, wie z.B. Wasser oder Wasser/Alkoholmischungen, auf die Zwischenschicht kaschiert und falls notwendig mit Hilfe eines Kalanders fest miteinander verbunden.

Ebenfalls möglich ist das Aufbringen der Zwischenschicht auf die IR-lichtempfindliche Schicht und das Aufbringen des Verbundes auf die Tiefdruckplatte.

Zur Belichtung der durch aktinisches Licht vernetzbaren Schicht (A) können die für Photopolymerdruckplatten üblichen UV-Lichtquellen (Hauptemissionsbereich 320 bis 400 nm) verwendet werden, beispielsweise Flachbelichter bestückt mit Leuchstoffröhren (z.B. Philips TL 10R 40W oder BASF nyloprint 40W BL 366). Der nyloprint Belichter 80 x 107 ist beispielsweise mit 18 Hochleistungs-UV-Leuchtstoffröhren dieser Art bestückt.

Das Auswaschen unbelichteter Bereiche von Photopolymerdruckplatten, Nachspülen und Vortrocknen kann mit den für diesen Zweck geeigneten handelsüblichen Auswaschsystemen durchgeführt werden. So arbeitet beispielsweise das nyloprint Auswaschsystem DW85 nach dem Reibeauswaschprinzip. Die Trocknung kann dann in sogenannten Durchlauftrocknern erfolgen, beispielsweise in einem nyloprint Durchlauftrockner DT85.

Die Kombination von Auswaschsystem mit Durchlauftrockner wird mit Durchlaufgerät nyloprint DW/DT85 bezeichnet.
Die in den Beispielen und Vergleichsbeispielen genannten Teile und Prozente beziehen sich, soweit nicht anders angegeben, auf das Gewicht.

Im Beispiel 1 wird die Herstellung eines erfindungsgemäßen, lichtempfindlichen Aufzeichnungselements beschrieben.

### Beispiel 1

Eine wasserlösliche IR-lichtempfindliche Schicht wurde durch Dispergieren bzw. Lösen von 2 Teilen Ruß (Printex U der Fa. Degussa) und 8 Teilen eines Polyvinylalkohols (z.B. KP 205 der Fa. Kuraray) in 80 Teilen Wasser und 20 Teilen n-Propanol hergestellt. Nach der Vereinigung der Bestandteile wurden diese in einem Dispergator (Ultra-Turrax) 2 Stunden behandelt, um eine feinteilige Dispersion herzustellen. Die so erhaltene Dispersion wurde auf eine Polyethylenterephthalatfolie (125 µm dick; z.B. Lumirror® der Fa. Toray Ind.) gegossen und zwar derart, daß der erhaltenen Film nach dem Trocknen eine Schichtdicke von 8 µm und eine optische Dichte 4,5 besaß. Danach wurde eine sauerstoffdurchlässige Schicht auf die IR-lichtempfindliche Schicht aufgebracht, die aus 45 Teilen Wasser und 2 Teilen eines teilverseiften Polyvinylalkohols (Mowiol 5-88 der Fa. Hoechst) hergestellt, auf die IR-empfindliche Schicht aufgegossen und sofort getrocknet wurde, und zwar so, daß die getrocknete sauerstoffdurchlässige Schicht eine Dicke von 6 µm hat.

Dieser Schichtverbund wurde auf eine handelsübliche wäßrig/alkoholisch auswaschbare Tiefdruckplatte auf Stahlblech, z.B. nylograv® ST 52 Tiefdruckplatte (Hersteller BASF Aktiengesellschaft) unter Verwendung von Propanol/Wasser (5:1) als Kaschierlösungsmittel aufkaschiert, nachdem man bei dieser Platte die Schutzfolie entfernt hatte.

Nach Abziehen der Schutzfolie wurde dieses lichtempfindliche Aufzeichnungsmaterial auf eine Vakuumtrommel montiert und mittels eines Nd-YAG-Lasers (Wellenlänge 1064 nm) belichtet. Der Spotdurchmesser des IR-Strahls war auf 20 µm eingestellt. Es handelte sich hierbei um einen Belichter der Fa. Baasel-Scheel. Anschließend wurde die Platte in einem nyloprint-Belichter B 80x107 vollflächig mit UV-Licht ohne Vakuum belichtet und in einem nach dem Reibeauswaschprinzip arbeitenden Durchlaufwascher, z.B. nylograv® DW100 EX/100 (BASF Aktiengesellschaft) mit Ethanol/Wasser (5:1)-Gemisch ausgewaschen, in einem Trockner, z.B. nylograv-Trockner FII, 30 Minuten bei 120°C getrocknet und anschließend nachbelichtet. Man erhielt eine Druckform mit einer hervorragenden Abstufung der Näpfchentiefen und einer Streuung der Näpfchentiefen bei konstanter Belichtungszeit von ± 1 µm und einem hervorragenden Druckergebnis. Die nichtdruckenden Bereiche waren absolut fehlerfrei.

### Vergleichsbeispiel 1

Eine wasserauswaschbare Tiefdruckplatte (z.B. nylograv® WSA 52 von BASF AG) wurde abweichend von Beispiel 1 im Vakuumrahmen durch ein Negativ hindurch mit UV-Licht vollflächig belichtet und nicht durch die Maske, die durch Laserablation der IR-lichtempfindlichen Schicht erzeugt wurde. Sowohl das Negativ als auch die Maske wurden aus demselben digitalen Datenbestand erzeugt; die geometrischen Abmessungen der für aktinisches Licht durchlässigen Bildteile waren bei beiden Verfahren somit absolut identisch. Nach den anschließenden Entwicklungsschritten (Auswaschen, Trocknen, Nachbelichten) erhielt man eine Druckform mit einer groben Abstufung der Näpfchentiefe und einer Streuung der Näpfchentiefe bei konstanter Belichtungszeit von ± 5 µm. Die fertige Druckform wurde auf einer Druckmaschine montiert und angedruckt. Das Druckergebnis entsprach dem Stand der Technik, Staubpartikel, die unter dem Negativ eingeschlossen und durch das Vakuum in die Oberfläche eingedrückt wurden, erzeugten beim Druck Fehler.

### Vergleichsbeispiel 2

Die IR-lichtempfindliche Schicht wurde wie in Beispiel 1 beschrieben, hergestellt. Danach wurde eine sauerstoffundurchlässige Schicht auf die IR-lichtempfindliche Schicht aufgebracht, die aus 45 Teilen Wasser und aus 2 Teilen eines vollständig verseiften Polyvinylalkohols (Mowiol 66-100 der Fa. Hoechst AG) hergestellt, auf die IR-lichtempfindliche Schicht aufgegossen und sofort getrocknet wurde, und zwar so, daß die getrocknete sauerstoffundurchlässige Schicht eine Dicke von 6 µm hatte.

Dieser Schichtverbund wurde auf eine handelsübliche Tiefdruckplatte, wie z.B. nylograv® WSA 52 wie in Beispiel 1 aufkaschiert, nachdem man bei dieser Platte die Schutzfolie entfernt hatte.

Dieses so hergestellte lichtempfindliche Aufzeichnungsmaterial wurde nach Abziehen der Schutzfolie auf eine Vakuumtrommel montiert und mittels eines Nd-YAG-Lasers (Wellenlänge 1064 nm) belichtet. Der Spotdurchmesser des IR-Strahls war auf 20 µm eingestellt. Auch hierbei wurde ein Belichter der Fa. Baasel-Scheel verwendet. Anschließend wurde die Platte in einem nyloprint-Belichter 80x107 mit UV-Licht vollflächig ohne Vakuum belichtet und in einem Durchlaufgerät nyloprint DW/DT 85 mit Wasser ausgewaschen, 30 Minuten bei 100°C getrocknet und nachbelichtet. Man erhielt eine Druckform mit einer schlechten Abstufung der Näpfchentiefen und einer Streuung der Näpfchentiefen bei konstanter Belichtungszeit von ± 10 µm. Das Druckergebnis war für die Anforderungen an eine Tiefdruckplatte unbrauchbar.

## Patentansprüche

1. Verfahren zur Herstellung von photopolymeren Tiefdruckplatten aus einem wässrig oder wässrig-alkoholisch entwickelbaren photopolymerisierbaren Aufzeichnungselement, umfassend übereinander angeordnet
- einen dimensionsstabilen Träger,
- optional eine Haftschicht,
- eine durch aktinische Strahlung vernetzbare Schicht (A),
- eine Trennschicht (T) zwischen (A) und (B),
- eine gegen IR-Strahlung empfindliche Schicht (B), sowie
- eine auf (B) angebrachte abziehbare Schutzfolie,
**dadurch gekennzeichnet, dass**
• die Schicht (A) aus einem Gemisch aus mindestens einem in Wasser oder Wasser/Alkohol-Gemischen löslichen oder dispergierbaren Bindemittel, mit diesem Bindemittel verträglichen copolymerisierbaren, ethylenisch ungesättigten organischen Verbindungen, einem Photoinitiator oder Photoinitiatorsystem sowie optional weiteren Hilfsstoffen besteht,
• die Trennschicht (T) sauerstoffdurchlässig und in Wasser oder Wasser/Alkohol-Gemischen löslich oder dispergierbar ist,
• die gegen IR-Strahlung empfindliche Schicht (B) im aktinischen Bereich eine optische Dichte ≥ 2,5 aufweist und ein in Wasser oder einem Wasser/Alkohol-Gemisch lösliches oder dispergierbares, filmbildendes polymeres Bindemittel sowie mindestens eine im Bindemittel fein verteilte Substanz, die im Wellenlängenbereich zwischen 750 nm und 20000 nm eine hohe Absorption aufweist, enthält,
indem nach Abziehen der Schutzfolie die Strukturierung der gegen IR-Strahlung empfindlichen Schicht (B) durch Laserablation erfolgt, dann vollflächig mit aktinischer Strahlung belichtet, mit Wasser oder Wasser/Alkohol-Gemischen entwickelt und in üblicher Weise getrocknet wird.

## Claims

1. A process for the production of photopolymer gravure printing plates from a photopolymerizable recording element which can be developed in an aqueous or aqueous alcoholic medium, comprising, arranged one on top of the other,
- a dimensionally stable substrate,
- optionally an adhesion-promoting layer,
- a layer (A) crosslinkable by actinic radiation,
- a parting layer (T) between (A) and (B),
- a layer (B) sensitive to IR radiation and
- a peelable protective film applied to (B),
wherein
• the layer (A) consists of a mixture of at least one binder soluble or dispersible in water or water/alcohol mixtures, copolymerizable, ethylenically unsaturated organic compounds compatible with this binder, a photoinitiator or photoinitiator system and optionally further assistants,
• the parting layer (T) is oxygen-permeable and is soluble or dispersible in water or water/alcohol mixtures,
• the layer (B) sensitive to IR radiation has an optical density ≥ 2.5 in the actinic range and contains a film-forming polymeric binder soluble or dispersible in water or in a water/alcohol mixture and at least one substance which is finely distributed in the binder and has a high absorption in the wavelength range from 750 to 20 000 nm,
by structuring the layer (B) sensitive to IR radiation by laser ablation after the protective film has been peeled off, then effecting uniform exposure to actinic radiation, developing with water or a water/alcohol mixture and drying in a conventional manner.

## Revendications

1. Procédé de fabrication de plaques photopolymères pour héliogravure, à partir d'un élément d'enregistrement photopolymérisable à développement aqueux ou hydro-alcoolique, comprenant, disposés l'un au-dessus de l'autre
. un support dimensionnellement stable,
. éventuellement, une couche adhésive,
. une couche (A) réticulable par un rayonnement actinique,
. une couche de séparation (T) entre (A) et (B),
. une couche (B) sensible au rayonnement IR, et
. une feuille de protection pelable, disposée sur (B),
**caractérisé en ce que**
• la couche (A) est constituée d'un mélange d'au moins un liant soluble ou dispersible dans l'eau ou dans des mélanges d'eau et d'alcool, de composés organiques à insaturation éthylénique et copolymérisables, compatibles avec ce liant, d'un photoamorceur ou d'un système photoamorceur, et éventuellement d'autres adjuvants,
• la couche de séparation (T) est perméable à l'oxygène et est soluble ou dispera dans l'eau ou dans les mélanges d'eau et d'alcool,
• la couche (B) sensible au rayonnement IR présente dans le domaine actinique une densité optique ≥ 2,5 et contient un liant polymère filmogène, soluble ou dispersible dans l'eau, ou dans un mélange d'eau et d'alcool, et au moins une substance finement divisée dans le liant, qui présente une forte absorption dans la plage de longueurs d'ondes comprise entre 750 et 20 000 nm,
dans lequel, après que la feuille de protection a été enlevée par pelage, on procède à une structuration, par ablation laser, de la couche (B) sensible au rayonnement IR, puis on éclaire en pleine surface par un rayonnement actinique, on développe avec de l'eau ou des mélanges d'eau et d'alcool, et on sèche d'une manière usuelle.
